Europäisches Patentamt

European Patent Office

Office européen des brevets

(19)

(11) EP 0 732 803 A1

(12) DEMANDE DE BREVET EUROPEEN

(43) Date de publication:
18.09.1996 Bulletin 1996/38

(51) Int Cl.⁶: H03D 3/00

(21) Numéro de dépôt: 96400529.2

(22) Date de dépôt: 14.03.1996

(84) Etats contractants désignés:
DE ES GB IT

(30) Priorité: 17.03.1995 FR 9503119

(71) Demandeur: VALEO ELECTRONIQUE
94000 Creteil (FR)

(72) Inventeurs:
• Lesther, Nicaise
F-94000 Créteil (FR)

• Pajonk, Jean-Claude
F-94000 Créteil (FR)

(74) Mandataire: Martin, Jean-Jacques et al
Cabinet REGIMBEAU
26, Avenue Kléber
75116 Paris (FR)

(54) Procédé et dispositif de démodulation par échantillonnage

(57) Procédé pour la démodulation d'un signal qui consiste en une porteuse modulée, dans legue pour obtenir un signal en bande de base dont on déduit les modulations en amplitude et/ou en phase recherchée, on échantillonne le signal à démoduler à une fréquence qui est inférieure à la fréquence de la porteuse et caractérisé et ce que, pour déterminer une valeur d'amplitude et/ou de phase de la porteuse modulé, on échantillonne celle-ci par deux impulsions successives séparées dans le temps d'un nombre impair de quarts de période de porteuse.

FIG.3a

FIG.3b

EP 0 732 803 A1

## Description

La présente invention est relative à un procédé et à un dispositif de démodulation par échantillonnage.

Elle trouve particulièrement avantageusement application pour la réception d'ondes ultrasonores modulées, par exemple dans un système d'alarme par ultrasons du type de ceux utilisés pour la protection de véhicules automobiles.

Classiquement, on utilise pour la démodulation d'un signal modulé en amplitude ou en phase des électroniques complexes présentant un nombre élevé de composants.

De telles électroniques comportent notamment généralement un amplificateur du signal démodulé permettant d'obtenir un signal traitable par un microcontrôleur standard (convertisseur analogique/ numérique 8 bits de type commercialisé sous la dénomination Série 6800 par MOTOROLA par exemple).

Elles devraient également comporter un microcontrôleur capable d'échantillonner le signal à haute fréquence (fréquence proche du MHz pour obtenir une bonne résolution) et présentant en outre une capacité de mémoire très importante. Dans la pratique, on met généralement en oeuvre en amont de l'échantillonnage des démodulations analogiques à des fréquences inférieures.

Ces électroniques ont une consommation importante de puissance électrique. Elles sont en outre d'un coût et d'un dimensionnement importants.

Le but de l'invention est de proposer un procédé et un dispositif de démodulation permettant de pallier ces inconvénients et de simplifier les matériels utilisés.

On connaît déjà par FR 2 573 589 un procédé de démodulation dans lequel la fréquence d'échantillonnage est inférieure aux fréquences du signal à démoduler et est en outre supérieure au double de la largeur des bandes du signal à démoduler.

On connaît également par EP 0 442 578 un dispositif de traitement d'un signal de télévision dans lequel le signal de fréquence intermédiaire est balayé par un signal dont la fréquence est un sous-multiple de cette fréquence intermédiaire.

L'invention propose quant à elle un procédé pour la démodulation d'un signal qui consiste en une porteuse modulée, dans lequel, pour obtenir un signal en bande de base dont on déduit,les modulations en amplitude et/ou en phase recherchée, on échantillonne le signal à démoduler à une fréquence qui est inférieure à la fréquence de la porteuse, caractérisé en ce que, pour déterminer une valeur d'amplitude et/ou de phase de la porteuse modulée, on échantillonne celle-ci par deux impulsions successives séparées dans le temps d'un nombre impair de quarts de période de porteuse.

L'invention concerne en outre un dispositif de démodulation mettant en oeuvre ce procédé.

Elle trouve avantageusement application pour les systèmes d'alarme à ultrasons, notamment pour véhicule automobile.

D'autres caractéristiques et avantages de l'invention ressortiront encore de la description qui suit. Cette description est purement illustrative et non limitative. Elle doit être lue en regard des dessins annexés sur lesquels :

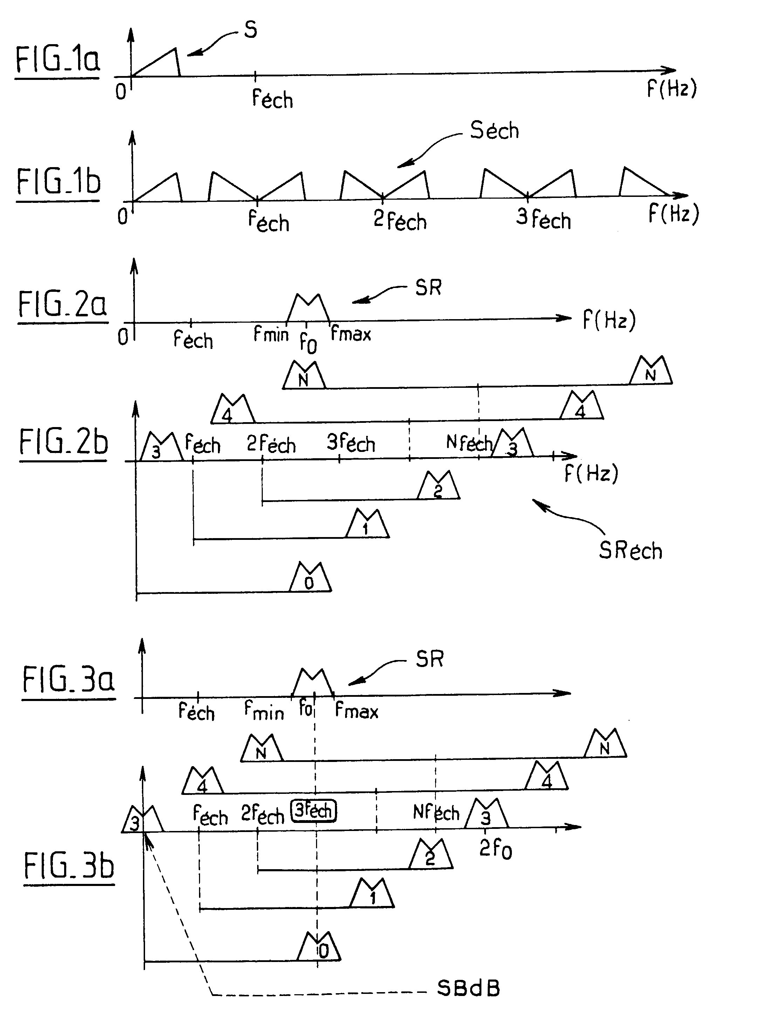

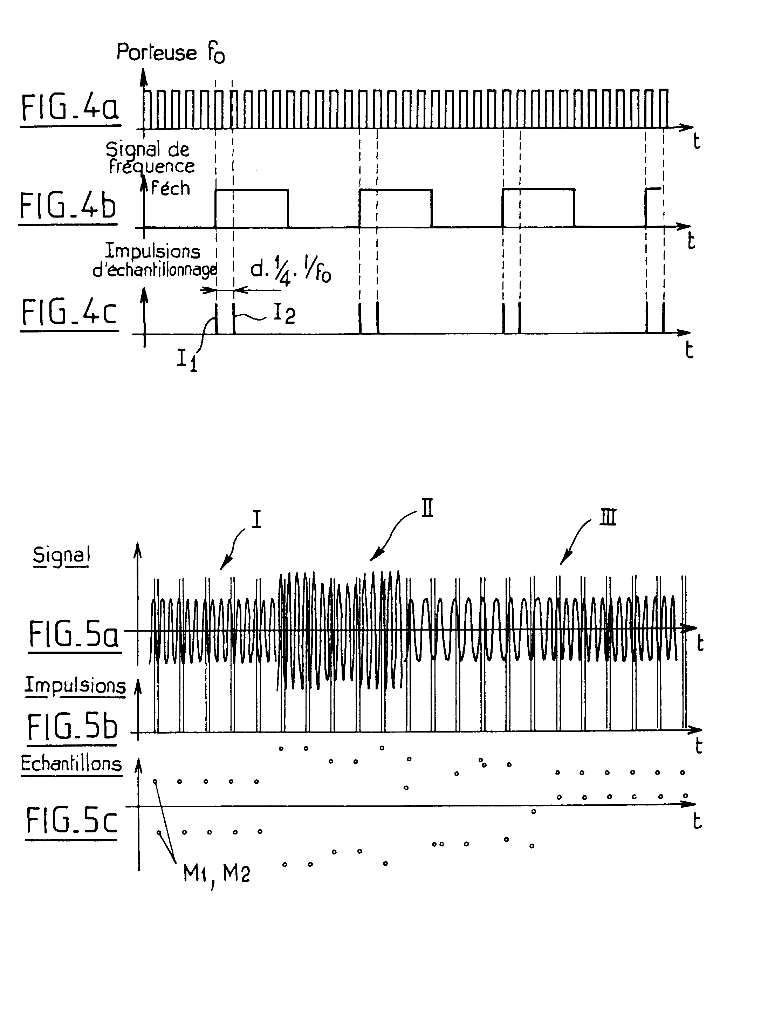

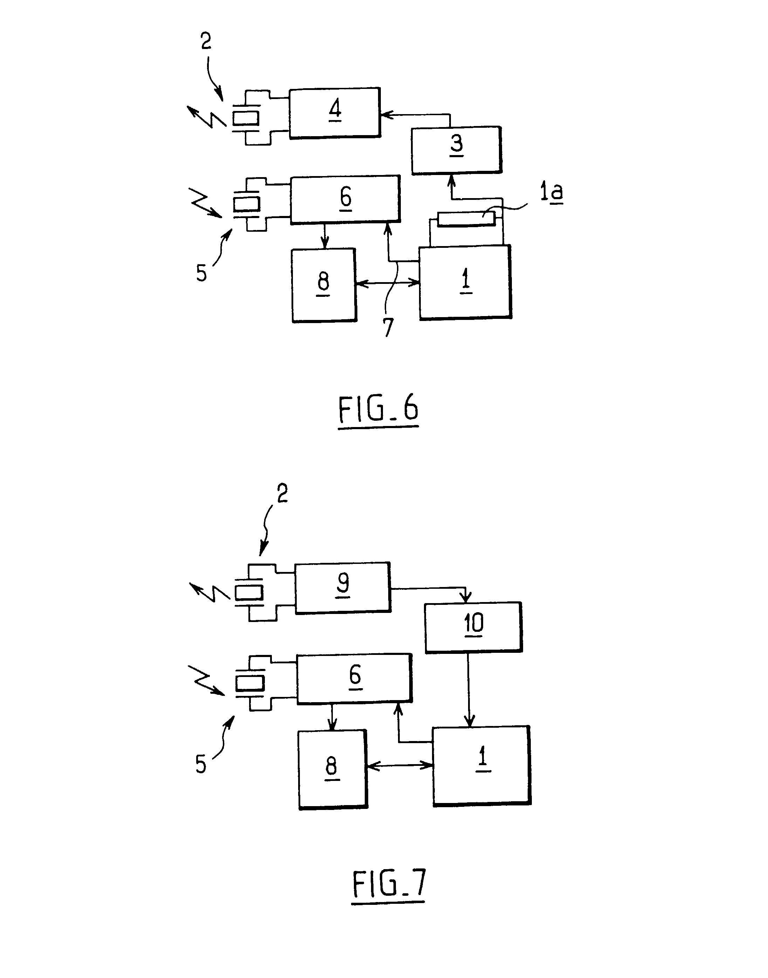

. les figures 1a et 1b représentent les spectres d'un signal avant et après échantillonnage par un signal de fréquence supérieure à la bande spectrale occupée par le signal ;
. les figures 2a et 2b représentent les spectres d'un signal avant et après échantillonnage par un signal de fréquence inférieure à la bande spectrale réelle du signal ;
. les figures 3a et 3b sont semblables aux figures 2a et 2b pour un signal d'échantillonnage sous-multiple de la fréquence de la porteuse du signal à démoduler ;
. les figures 4a à 4c illustrent un mode de mise en oeuvre possible de l'invention et représentent respectivement la porteuse du signal à démoduler, un signal de référence dont la fréquence est la fréquence d'échantillonnage, ainsi que les impulsions d'échantillonnage mises en oeuvre ;
. les figures 5a à 5c illustrent pour un exemple de signal modulé en amplitude et en phase (figure 5a), les points d'échantillonnage obtenus (figure 5c) avec des impulsions d'échantillonnage (figure 5b) correspondant au mode de mise en oeuvre illustré sur les figures 4a à 4c ;
. la figure 6 est une représentation schématique d'un dispositif conforme à un mode de réalisation possible pour l'invention ;
. la figure 7 est une représentation par schémabloc semblable à celle de la figure 6 pour un autre mode de réalisation possible.

Sur la figure 1a, on a représenté le spectre S d'un signal à échantillonner.

On sait que l'échantillonnage d'un signal a pour effet de rendre périodique le spectre de celui-ci dans l'espace des fréquences (convolution d'un peigne de Dirac avec le signal traité).

Sur la figure 1b, on a représenté le spectre $S_{éch}$ du signal correspondant au signal de spectre S échantillonné à la fréquence $f_{éch}$.

Comme on peut le voir sur ce spectre $S_{éch}$, la période de récurrence du spectre S du signal initial correspond, sur toute l'étendue spectrale, à la fréquence d'échantillonnage $f_{éch}$.

Toutefois, ainsi qu'on l'a illustré sur la figure 2a, la bande spectrale réellement occupée par un signal ne s'étend généralement pas jusqu'à la fréquence de 0 Hz, le spectre réel SR étant généralement de composante nulle aux abords de la fréquence de 0 Hz. Sur la figure 2a, la fréquence la plus petite du spectre SR a été référencée par fmin, la fréquence la plus élevée par fmax. La fréquence f0 qui est la fréquence milieu entre la fréquence fmin et la fréquence fmax est la fréquence de la porteuse du signal.

Si la fréquence d'échantillonnage est choisie inférieure à la fréquence fmin, le spectre $SR_{éch}$ du signal échantillonné est du type de celui illustré sur la figure 2b : il est la somme des différentes composantes de spectre 0 à N correspondant chacune à une récurrence d'échantillonnage.

Comme on l'aura compris en se référant à cette figure 2b, en choisissant judicieusement la fréquence d'échantillonnage, il est possible d'obtenir un signal en bande de base (correspondant à l'une des composantes 0 à N), dont on peut déduire les modulations en amplitude et/ou en phase recherchée.

Dans un mode de mise en oeuvre préférentiel, on choisit la fréquence d'échantillonnage $f_{éch}$ de façon que celle-ci soit un sous-multiple de la fréquence fO de la porteuse (f0 = k.$f_{éch}$, où k est un nombre entier).

La $k^{ième}$ composante du spectre du signal après échantillonnage est alors constituée de deux sous-spectres, dont l'un est centré sur 0 Hz, l'autre étant centré sur la fréquence 2.f0.

Par conséquent, le signal d'origine est précisément ramené au signal en bande de base SBdB correspondant aux modulations recherchées.

C'est ce qui a été illustré sur les figures 3a et 3b pour une valeur de k égale à 3.

Dans un mode de réalisation particulièrement avantageux, la porteuse et le signal d'échantillonnage sont synchrones (fréquence d'échantillonnage sous multiple exact de la fréquence de la porteuse). En l'absence de ce synchronisme, il apparaît en effet une gîte du spectre en bande de base autour de zéro, et donc des fréquences supplémentaires artificielles qui sont source d'erreurs.

Par ailleurs, de façon également préférée, on choisit la fréquence d'échantillonnage $f_{éch}$ supérieure à la largeur fmax-fmin de la bande spectrale réellement occupée par le signal d'origine. Ceci permet d'éviter des recouvrements entre les composantes de spectre correspondant à des récurrences différentes.

On évite ainsi que les composantes de spectre s'additionnent pour donner un résultat complexe qui dégrade l'information portée par le signal d'origine.

On se réfère aux figures 4a à 4c sur lesquelles on a illustré un mode de mise en oeuvre possible de l'invention.

La figure 4a représente la porteuse de fréquence f0 du signal à démoduler.

Ce signal à démoduler est par exemple d'une largeur de bande $\pm$ F.

La fréquence d'échantillonnage est choisie supérieure à 2F. Elle est égale à f0/k, où k est très inférieur à f0/2F. On a représenté sur la figure 4b un signal carré dont la fréquence est la fréquence d'échantillonnage et qui est synchronisé avec la porteuse représentée sur la figure 4a.

Ainsi qu'on l'a illustré sur la figure 4c, on génère, à partir de ce signal de fréquence $f_{éch}$, deux impulsions I1 et I2 séparées dans le temps d'un nombre d impair de quarts de période de la porteuse.

Cet écart temporel est très inférieur à la période du signal de référence de fréquence $f_{éch}$ représentée sur la figure 4b (d inférieur à 4.k).

Ainsi, grâce à ces deux impulsions successives I1 et I2, on relève deux échantillons M1 et M2, l'un à l'instant n.k.T (T=1/f0), l'autre à un instant n.k.T + d.T/4.

Ces deux impulsions permettent par conséquent de mesurer les composantes sinus et cosinus du signal modulé.

Plus particulièrement, les valeurs des deux échantillons M1 et M2 sont les suivantes :

$$M1(n.k.T)=A(n.k.T)\sin(2\pi.f0.n.k.T+\phi(n.k.T))$$

et

$$M2(n.k.T+d.T/4)=A(n.k.T+d.T/4)\sin(2\pi,f0(n.k.T+d.T/4)\ +\phi(n.k.T+d.T/4)),$$

où A et $\phi$ sont les amplitude et phase correspondant à la modulation, c'est-à-dire :

$$M1(n.k.T)=A(n.k.T)\sin(\phi(n.k.T))$$

et

$$M2(n.k.T+d.T/4)=A(n.k.T+d.T/4)\cos(\phi(n.k.T+d.T/4)).$$

Etant donné que d < 4.k, et que le signal modulant est considéré comme constant durant la période d'échantillonnage, on peut considérer que les deux égalités suivantes sont vérifiées :

$$A(n.k.T) \neq A(n.k.T+d.T/4)$$

et

$$\phi(n.k.T) \neq \phi(n.k.T+d.T/4).$$

Par conséquent, les valeurs M1 et M2 sont traitées par une unité de calcul à laquelle elles sont transmises pour retrouver les valeurs de A et de $\phi$ à l'instant n.k.T.

A titre d'exemple, sur la figure 5a, on a représenté un signal :

- dont une première partie, référencée par I, est non modulée et correspond à la porteuse de fréquence f0, par exemple de 40 kHz,
- dont une deuxième partie, référencée par II, correspond à la même porteuse modulée en amplitude
- et dont une troisième partie, référencée par III, illustre une modulation de fréquence autour de la fréquence de la porteuse.

Les valeurs M1 et M2 obtenues à partir de ce signal avec des impulsions d'échantillonnage à la fréquence de 400 Hz (k=100, d=10, F=100 Hz) telles qu'illustrées sur la figure 5b, ont été portées sur la figure 5c.

Sur la figure 6, on a illustré un mode de réalisation d'un dispositif d'alarme à ultrasons mettant en oeuvre le procédé qui vient d'être décrit.

Ce dispositif comporte un microcontrôleur 1 dont l'horloge interne la (résonateur à la fréquence de 2 MHz) est utilisée pour piloter un émetteur 2 d'ultrasons, dont la fréquence est de 40 kHz. A cet effet, la sortie de l'horloge la du microcontrôleur 1 est reliée à un diviseur de fréquence par 50, référencé par 3. Ce diviseur de fréquence 3 transmet un signal à la fréquence de 40 kHz à une unité 4 qui commande l'émetteur 2.

Les ultrasons réfléchis par l'environnement dans lequel se trouve le dispositif sont détectés par un capteur 5, dont la sortie est envoyée sur un amplificateur 6. Le signal traité par l'amplificateur 6 est échantillonné par le microcontrôleur 1 (réaction 7) à la fréquence de 400 Hz. Les signaux échantillonnés sont transmis à une unité 8 de conversion analogique/numérique en entrée du microcontrôleur 1 (CAN 12 bits).

Les valeurs M1 et M2 des échantillons ainsi relevés sont traitées par le microcontrôleur 1 pour retrouver l'amplitude et la phase correspondant à ces échantillons.

Ces informations sont ensuite exploitées pour interpréter la modulation du signal reçu et déduire la présence éventuelle d'un intrus dans l'environnement observé.

On notera que, dans ce mode de réalisation, le signal d'échantillonnage et la porteuse sont nécessairement synchrones puisqu'ils sont tous deux générés par le microcontrôleur 1.

Une variante de réalisation a été illustrée sur la figure 7.

Le dispositif conforme à cette variante comporte également un microcontrôleur 1, un récepteur d'ultrasons 5, un amplificateur 6, ainsi qu'un convertisseur analogique/numérique 8.

L'émetteur d'ultrasons 2 est commandé par une source de fréquence 9 de 40 kHz. Le signal interne du microcontrôleur 1 qui commande les impulsions d'échantillonnage est synchronisé sur cette source de fréquence 9.

A cet effet, une sortie de la source 9 est envoyée sur un diviseur 10 de fréquence par 100. Le signal de 400 Hz en sortie du diviseur 10 est envoyé sur une entrée analogique (avec convertisseur analogique-numérique intégré) du microcontrôleur 1, afin de synchroniser le signal interne de commande des impulsions d'échantillonnage.

On notera que le signal de synchronisation reçu de la source 9 doit être un signal de basse fréquence de façon à permettre au microcontrôleur de le récupérer avec une bonne précision, sans avoir à mettre en oeuvre des traitements trop importants.

**Revendications**

1. Procédé pour la démodulation d'un signal qui consiste en une porteuse modulée, dans lequel, pour obtenir un signal en bande de base dont on déduit les modulations en amplitude et/ou en phase recherchée, on échantillonne le signal à démoduler à une fréquence qui est inférieure à la fréquence de la porteuse, caractérisé en ce que, pour déterminer une valeur d'amplitude et/ou de phase de la porteuse modulée, on échantillonne celle-ci par deux impulsions successives séparées dans le temps d'un nombre impair de quarts de période de porteuse.

2. Procédé selon la revendication 1, caractérisé en ce que la fréquence d'échantillonnage est un sous-multiple de la fréquence de la porteuse.

3. Procédé selon la revendication 2, caractérisé en ce que la fréquence d'échantillonnage est supérieure à la largeur de bande spectrale de la porteuse modulée.

4. Dispositif de démodulation d'un signal qui consiste en une porteuse modulée, caractérisé en ce qu'il comporte des moyens (1, 5 à 8) pour échantillonner la porteuse modulée à une fréquence qui est inférieure à la fréquence de sa porteuse de façon à mettre en oeuvre le procédé selon l'une des revendications précédentes.

5. Dispositif selon la revendication 4, caractérisé en ce qu'il comporte des moyens (5, 6) pour la réception de la porteuse modulée, ainsi qu'un microcontrôleur (1) relié auxdits moyens de réception, ledit microcontrôleur (1) commandant l'échantillonnage du signal reçu par lesdits moyens de réception (5,6) et calculant les paramètres de modulation de phase et/ou d'amplitude en fonction des valeurs d'échantillonnage reçues desdits moyens de réception.

6. Dispositif selon l'une des revendications 4 et 5, caractérisé en ce qu'il comporte des moyens (3, 10) pour synchroniser les moyens d'échantillonnage (1, 5 à 8) et une source d'émission (4,9) à l'origine de la porteuse du signal à démoduler, la fréquence d'échantillonnage est un sous-multiple exact de la fréquence de la porteuse.

7. Dispositif selon les revendications 5 et 6 prises en combinaison, caractérisé en ce qu'il comporte des moyens (3) pour synchroniser la source d'émission (4) sur un signal d'horloge du microcontrôleur (1).

8. Dispositif selon les revendications 5 et 6 prises en combinaison, caractérisé en ce qu'il comporte des moyens (3) pour synchroniser un signal interne du microcontrôleur (1) sur la source d'émission (9).

9. Système d'alarme à détection par ultrasons, notamment pour véhicule automobile, comportant des moyens pour l'émission d'ultrasons (2), des moyens (1, 5 à 8) pour la réception d'ultrasons réfléchis et pour la détection d'une intrusion en fonction de la modulation des ultrasons reçus, caractérisé en ce que ces moyens de réception et de détection comportent un dispositif selon l'une des revendications 4 et suivantes.

FIG.1a

FIG.1b

FIG.2a

FIG.2b

FIG.3a

FIG.3b

Porteuse f$_0$

FIG.4a

t

Signal de
fréquence
f éch

FIG.4b

t

Impulsions
d'échantillonnage

d.¼. ¹/f$_0$

FIG.4c

I$_2$

I$_1$

t

Signal

I    II    III

FIG.5a

t

Impulsions

FIG.5b

t

Echantillons

FIG.5c

M$_1$, M2

t

FIG.6

FIG.7

<table>
<tr><td colspan="2">Office européen<br>des brevets</td><td>RAPPORT DE RECHERCHE EUROPEENNE</td><td>Numero de la demande<br>EP 96 40 0529</td></tr>
</table>

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| D,A | FR-A-2 573 589 (ZELLWEGER USTER S.A.)<br>* revendication 1 *<br>--- | 1-4 | H03D3/00 |
| D,A | EP-A-0 442 578 (PHILIPS PATENTVERWALTUNG GMBH)<br>* revendications 1,5 *<br>--- | 2,6 | |
| A | EP-A-0 461 720 (N.V. PHILIPS' GLOEILAMPENFABRIEKEN)<br>* le document en entier *<br>--- | 1,2 | |
| A | EP-A-0 285 252 (BRITISH AEROSPACE PUBLIC LIMITED COMPANY)<br>----- | | |

**DOMAINES TECHNIQUES RECHERCHES (Int.Cl.6)**

H03D

Le présent rapport a été établi pour toutes les revendications

| Lieu de la recherche | Date d'achèvement de la recherche | Examinateur |
|---|---|---|
| LA HAYE | 3 Juin 1996 | Peeters, M |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
-------------------------------------------------------
& : membre de la même famille, document correspondant

EPO FORM 1503 03.82 (P04C02)